# EUROPEAN PATENT APPLICATION

(11) **EP 0 582 397 A2**
(43) Date of publication of application: **09.02.1994**
(21) Application number: 93305615.2
(22) Date of filing: 16.07.1993
(51) Int. Cl.: G01T 1/202, C23C 16/26

(54) **CVD diamond material for radiation detector and process for making same**

(30) Priority: 05.08.1992 US 926208
(71) Applicant: CRYSTALLUME, Menlo Park California 94025 (US)
(72) Inventor: Plano, Mary Anne, Fremont, California 94539 (US); Landstrass, Maurice I, Pacifica, California 94044 (US)
(74) Representative: Senior, Alan Murray

(57) **Abstract**

CVD diamond films useful for radiation detectors comprise diamond films having an average grain size of at least 7 microns and contain minimal hydrogen, which may be grown on substrates having deposited diamond films of a similar grain size. The diamond films of the present invention have a carrier mobility of at least 1,000 cm²/V-sec, a carrier lifetime of at least 100 psec and less than 200 nsec, yielding a collection distance of at least 10 microns at an electric field strength of 10⁴ V/cm, and a resistivity of at least 10¹⁰ Ω-cm. A surface radiation detector and a bulk radiation detector are fabricated using the CVD diamond materials of the present invention. A chemical-vapor-deposition method is disclosed for producing diamond materials suitable for use as radiation detectors according to the present invention. The diamond material of the present invention is grown on a suitable substrate material, such as large-grain polycrystalline diamond, single crystal diamond, diamond particulate composites and other non-diamond substrates that allow for large grain growth. A NIRIM style CVD reactor having a reactor chamber volume of about 300 in³, may be used. Microwave energy of 2.45 GHz at a power level of between about 1,400 to 1,900 watts is introduced to create a plasma in the region of a substrate holder and achieve a substrate temperature of between about 800-1,000°C. The reaction may be carried out in an atmosphere of 300 sccm of hydrogen, 3 sccm of methane, and 4.5 sccm of carbon monoxide at pressures from 90-100 Torr, and substrate temperatures of 800-1000° C.

## Description

### BACKGROUND OF THE INVENTION

### 1. Field Of The Invention

The present invention relates to chemical vapor deposited diamond materials. More particularly, the present invention relates to CVD diamond materials suitable for making detectors for detecting radiation, such as x-rays, gamma rays, ultraviolet, high energy particles, and the like, and to processes for fabricating such materials.

### 2. The Prior Art

Materials comprising doped silicon junctions have been used as radiation detectors. The closest known prior art is the use of natural diamond for detectors for detecting radiation, such as ultraviolet, x-rays, gamma rays, high energy particles, and the like.

The use of natural diamond as a radiation detector is no new. Hofstader described diamond detectors in a 1949 issue of Nucleonics. In fact, the first solid state detector used was natural diamond, presumably, because sizable crystals of natural diamond were more readily available than crystals of silicon or germanium. Such a detector detects radiation which is capable of producing free current carriers in diamond. Typically, such radiation includes light and energetic particles which have energies greater than 5.45 eV.

Despite its early development, natural diamond did not find wide spread use as a radiation detector due to several disadvantages associated therewith. First, natural diamond is obviously prohibitively expensive in large-sized crystals. Second, the large resistivity of natural diamond causes a buildup of trapped charge when the diamond is exposed to radiation. The inevitable presence of impurities and crystal defects cause some amount of the ionized charge to be trapped. Since, in a large band-gap material like diamond, some of the trapping centers may be far below the conduction band, the trapping time is very long. Therefore, charge builds up and causes a reduction in the effective collection field. Third, because natural diamond contains a large amount of impurities, particularly nitrogen, the carrier lifetime is short and the collection efficiency for a moderately thick detector is small.

Kozlov et al. have extensively studied natural diamond as a radiation detector. They measured the response of natural diamond to alpha particles and determined the energy resolution. In addition, they found that the carrier lifetime is a function of the nitrogen impurity concentration. For diamond with a nitrogen concentration less than 10¹⁹/cm³, the measured lifetimes were greater than 1 nsec. The resistance of the diamond detectors to radiation damage caused by neutrons was also measured.

A technology for fabricating synthetic diamond materials by chemical vapor deposition (CVD) has recently been developed. This technology has the potential for solving these problems and allows diamond to be grown in large sheets at a reasonable cost. Although it has been theoretically feasible to fabricate commercially-acceptable radiation detectors from synthetic CVD diamond materials to avoid the inherent problems associated with natural diamond, to date there have been no successful attempts at producing CVD diamond radiation detectors having commercially-useful characteristics.

Recently, researchers at Livermore National Laboratory and Stanford University have succeeded in measuring signals in CVD diamond exposed to a flux of synchrotron radiation X-rays from SPEAR. The diamond samples were uniformly illuminated by a 350 psec pulse of X-rays. The lifetimes of generated carriers were determined by measuring the decay time of the signal and the mobilities of the carriers were determined by measuring the amplitude of the signal which is proportional to the product of the mobility and the carrier lifetime.

Two sets of samples, produced by two different CVD processes, were used in these measurements. In one sample, the grain sizes were 0.6 to 1.5 microns. Carrier lifetimes from 90 to 300 ps and mobilities from 0.01 to 1.0 cm²/V-s were measured for these samples. In the second set of samples, the grain sizes were 4 to 20 microns. In these samples, carrier lifetimes from 150 to 200 ps and mobilities from 100 to 1000 cm²/V-s were observed. Although these studies have demonstrated that process improvements can improve the electrical characteristics of the sample, they still do not demonstrate commercially-acceptable CVD diamond detector material.

In order to attain detector-quality CVD diamond, carrier lifetimes and mobilities will have to be improved. The present low carrier lifetimes are likely due to defects within individual crystals. Measurements have also verified that there is a strong correlation between nitrogen concentration and carrier lifetime. A piece of natural diamond with a nitrogen concentration of 2 x 10²⁰/cm³ had a carrier lifetime of 300 psec.

It seems likely, therefore, that if the purity of the diamond is high, the carrier lifetime will be sufficiently long. The purity required to achieve high carrier lifetimes can be attained with the CVD process. The remaining problem is to reduce the crystal defect density in CVD diamond.

Further work by this group has involved diamond CVD deposition on substrates other than silicon and routine analysis of samples provided by manufacturers on bulk and surface properties of the samples. In order to attain consistently high quality diamond at low cost, a reasonable substrate must be found and its properties measured. In addition to the work described above, researchers from Rutgers University and Ohio State University have observed charged particle tracks from α and β sources using high-pressure synthetic single crystal diamond. This diamond had a large nitrogen concentration and, therefore, a short carrier lifetime. As a result, the observed pulse heights for both theα and β sources was about 5% of that expected from the calculated energy loss.

Although this particular sample is unsatisfactory as a radiation detector, this work demonstrates that the capability exists for detecting signals from a single charged particle traversing a layer of diamond a few hundred microns thick. In fact, for a diamond detector with high collection efficiency, the signal size will be 20 times larger.

The provision of such CVD diamond radiation detectors would provide a unique opportunity for investigating a new unexplored energy region in high-energy physics. Experiments using such detectors in tracking detectors and calorimeters could be capable of definitive searches for the Higgs, supersymmetry, technicolor, compositeness, etc., which so far have eluded experimental detection, as well as the ability to recognize unanticipated phenomena. The signatures for new physics include the production of high transverse momentum leptons, jets and missing energy. For example, Higgs searches require lepton and jet reconstruction while supersymmetry and technicolor searches require finely segmented hermetic calorimetry to determine the missing energy.

Further, since the scale of these new interactions is unknown, hydron colliders operating at a luminosity in excess of 10³⁴ cm⁻² sec⁻¹ would be a very desirable property. A detector that can function at this luminosity will have to operate in a very high radiation environment and must be able to handle extremely high event rates. No existing detector technology completely fulfills these requirements. As a result, a generic detector based on present-day technology will have unwanted compromises.

It is therefore an object of the present invention to provide a CVD diamond material having properties which make it suitable for use as a radiation detector element.

A further object of the invention is to provide a commercially-acceptable radiation detector incorporating a CVD diamond detector element.

Yet another object of the invention is to provide a fabrication process for a CVD diamond material having properties which make it suitable for use as a radiation detector element.

### BRIEF DESCRIPTION OF THE INVENTION

The present invention comprises a radiation detector based on the novel use of diamond technology to survive in a high radiation environment and methods for fabricating such detectors. The diamond detectors of the present invention detect radiation,which is capable of producing free current carriers in diamond. Typically, such radiation includes light and energetic particles which have energies greater than 5.45 eV.

According to a first aspect of the present invention, CVD diamond films useful for radiation detectors comprise diamond films having an average grain size of at least 7 microns, and preferably at least 15 microns. The grain size of the best material produced to date has been 15 microns. The films of the present invention are typically grown on substrates having deposited diamond films of a similar grain size. The diamond materials of the present inventions preferably contain no more than minimal amounts of nitrogen.

The diamond films of the present invention have a carrier mobility of at least 1,000 cm²/V-sec, a carrier lifetime of at least 100 psec and less than 200 nsec, yielding a collection distance of at least 10 microns at an electric field strength of 10⁴ V/cm. The diamond films of the present invention have a resistivity of at least 10¹⁰ Ω-cm. Measurements of the surface layer by time resolved photoconductivity indicate combined mobilities as high as 4000-5000 cm2/V-sec and carrier lifetimes of as high as 1500 picoseconds.

According to a second aspect of the present invention, radiation detectors are fabricated using the CVD diamond materials of the present invention. A surface radiation detector comprises a diamond film grown according to the teachings of the present invention. The diamond film should have a minimum thickness of about 1 microns and an area of at least about 1 mm². The maximum thickness of such a diamond film is relatively unimportant, since only the surface layer is utilized.

According to a first embodiment, a set of first parallel conductive strips and a second set of parallel conductive strips, offset from and spaced apart from the first set of parallel strips, are disposed on the surface of the diamond film. The conductive strips preferably comprising a deposited titanium/gold film. A plurality of active detector areas comprises the regions between pairs of first and second conductive strips. According to a second embodiment, a plurality of parallel conductive strips, preferably comprising a titanium/gold film layer, are disposed on the surface of the diamond film and spaced apart by a selected active region distance. Alternating ones of the conductive strips are electrically connected to one another, preferably by one of two regions of the titanium/gold film layer disposed adjacent to the periphery of the measuring area of the film and running orthogonal to and in contact with alternating ones of the conductive strips to form an interlaced comb-like pattern.

A bulk radiation detector according to the present invention comprises a block of diamond film having an upper surface and a lower surface, and having a thickness of between about 10 microns and several hundred microns. According to a first embodiment, an upper layer and a lower layer of conductive film, preferably comprising a deposited titanium/gold layer, are respectively disposed over an area of about 1 mm² or larger on each of the upper and lower surfaces of the block of diamond film. The upper and lower film layers are aligned to one another. According to a second embodiment, a layer of conductive film, preferably comprising a deposited titanium/gold layer, is disposed over an area of about 1 mm² or larger on one of the upper and lower surfaces. A plurality of spaced apart parallel conductive strips are disposed on the other one of the upper and lower surfaces of the block.

According to a third aspect of the present invention, a chemical-vapor-deposition method for producing diamond materials suitable for use as radiation detectors is disclosed. The diamond material of the present invention is grown on a suitable substrate material. Appropriate substrates include large grain polycrystalline diamond, single crystal diamond, diamond particulate composites and other non-diamond substrates that allow for large grain growth.

According to the present invention, detector-grade diamond can be grown using microwave plasma CVD techniques. Diamond materials according to the present invention have been successfully grown in a NIRIM-style microwave plasma CVD reactor having a reactor chamber volume of about 300 in³. Microwave energy of 2.45 GHz at a power level of between about 1,400 to 1,900 watts is introduced into the reactor chamber to create a plasma in the region of a substrate holder and achieve a substrate temperature of between about 800-1,000°C. The reaction may be carried out in an atmosphere of hydrogen, methane, and carbon monoxide. Detector grade diamond has been grown using gas flow rates of 300 sccm of hydrogen, 3 sccm of methane and 4.5 sccm of carbon monoxide at pressures from 90-100 Torr and substrate temperatures of 800-1000° C.

### BRIEF DESCRIPTION OF THE DRAWINGS

FIG. 1 is a photomicrograph of CVD diamond material produced according to the present invention.

FIG. 2 is a diagram of a top view of a surface radiation detector according to a first embodiment of the invention.

FIG. 3 is a diagram of a top view of a surface radiation detector according to a second embodiment of the invention.

FIG. 4 is a diagram of a cross section of a bulk radiation detector according to a first embodiment of the invention.

FIG. 5 is a diagram of a cross section of a bulk radiation detector according to a second embodiment of the invention.

FIG. 6 is a face view of a showerhead gas delivery apparatus suitable for use in the present invention.

### DETAILED DESCRIPTION OF A PREFERRED EMBODIMENT

Those of ordinary skill in the art will realize that the following description of the present invention is illustrative only and not in any way limiting. Other embodiments of the invention will readily suggest themselves to such skilled persons.

According to the present invention, a novel CVD diamond material and radiation detectors made from the CVD diamond material are disclosed. The radiation detectors of the present invention can be made in larger dimensions -and at a lower cost than natural diamond detectors. The CVD diamond materials of the present invention have a major advantage over other suitable detector materials since it has the highest inherent resistance to radiation damage. In applications where a high total radiation dose can be contemplated, CVD diamond radiation detectors enable a large reduction in detector size compared to other solid-state detectors. The CVD diamond materials of the present invention are also an obvious choice as an ultraviolet detector due to their large band gap (i.e., 5.5 eV).

Detector-grade diamond must have minimum electronic transport properties for the detector to function properly. By controlling CVD growth chemistry and grain size during growth, CVD diamond with the appropriate electronic properties can be fabricated. It has been found that CVD diamond material of the present invention can be grown with mobilities larger than and other pertinent properties better than those found in other CVD diamond and in natural diamond materials. The CVD diamond material of the present invention have carrier lifetimes comparable to that of natural diamond. The fabrication of this superior diamond material may be accomplished using the combination of large grain size and deposition chemistry disclosed herein.

According to a first aspect of the present invention, CVD diamond films suitable for use as surface radiation detectors have a minimum thickness of about 1 micron. Since only the upper surface is utilized in such a detector, the upper thickness limit is based on practical process-time considerations. CVD diamond films suitable for use as bulk radiation detectors have a thickness of from between about 10 microns to several hundreds of microns depending on the type of radiation to be measured and the desired response speed. In both instances, these films have an average grain size of at least 7 microns and preferably around 15 microns, and contain minimal hydrogen.

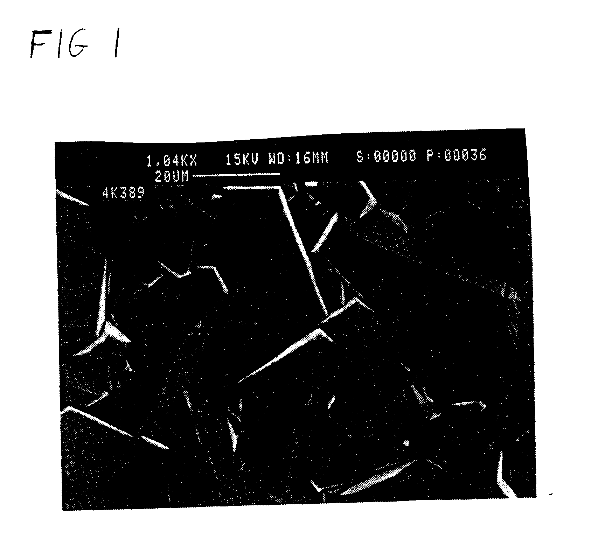

The CVD diamond films of the present invention have advantageous electrical properties which make them more suitable for use as radiation detectors than other CVD diamond films. The CVD diamond films of the present invention have a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm. FIG. 1 is a photomicrograph of a sample of CVD diamond material suitable for radiation detectors according to the present invention.

According to a second aspect of the present invention, surface and bulk radiation detectors are fabricated using the CVD diamond materials of the present invention. A surface radiation detector comprises a diamond film grown according to the teachings of the present invention. The diamond film should have a minimum thickness of about 1 micron and an area of about 1 mm² or larger. The maximum thickness of the diamond film for use as a surface detector is relatively unimportant since only the top surface of the film is utilized.

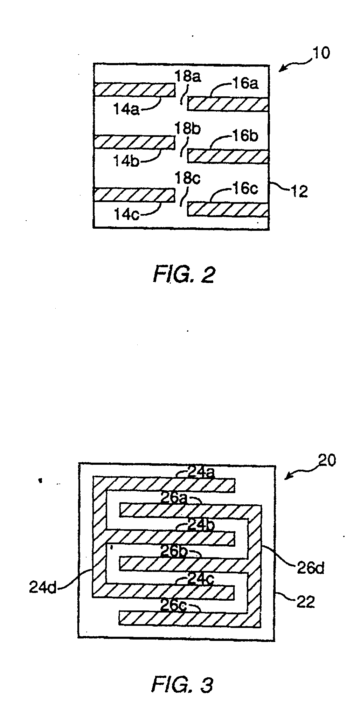

Referring first to FIG. 2, a first embodiment of a surface radiation detector 10 according to the present invention comprises a CVD diamond film 12 grown according to the present invention. A plurality of first conductive strips 14a, 14b, and 14c, offset from a plurality of second conductive strips 16a, 16b, and 16c, are disposed on the detecting surface of the diamond film 12. As described below, the conductive strips may preferably comprise a titanium/gold film. A plurality of active detector areas comprises the regions 18a, 18b, and 18c located between pairs of first and second conductive strips. In a typical embodiment, strips 14a and 16a may be 1 mm wide and may be offset from one another by spaces 18a and 18b of about 1mm.

To fabricate the radiation detector of FIG. 2, the CVD diamond film is prepared by removing any non-electronic grade diamond or other material from the areas to be metallized for the active device. This may be accomplished using conventional materials processing etch steps.

Next, the prepared active surface of the detector is metallized with an appropriate metal pattern. As presently preferred, a set of first parallel conductive strips and a second set of parallel conductive strips, offset from and spaced apart from the first set of parallel strips, are disposed on the surface of the diamond film. The conductive strips preferably comprising a deposited titanium film having a thickness of about 500 Å followed by gold film having a thickness of about 10,000 Å or a titanium film having a thickness of about 500 Å, or a similar metal system. Electrical leads may be bonded to the metal films using conventional semiconductor processing techniques. The three separate detector devices depicted in FIG. 2 could be either further diced into individual detectors or may be used as an array.

A second embodiment of a surface detector is shown in top view in FIG. 3. The surface radiation detector 20 of the embodiment of FIG. 2 comprises a CVD diamond film 22 grown according to the present invention. A plurality of first conductive strips 24a, 24b, and 24c, interleaved with a plurality of second conductive strips 26a, 26b, and 26c, are disposed on the detecting surface of the diamond film 22. Strips 24a-24c are joined at the periphery of the detector area by orthogonally disposed contiguous strip 24d and strips 26a-26c are joined at the periphery of the detector area by orthogonally disposed contiguous strip 26d . A plurality of active detector areas comprises the regions located between pairs of first and second conductive strips. In a typical embodiment strips 24a and 26a may be about 5 microns wide and may be separated from one another by about micron.

To fabricate the surface detector of FIG. 3, a CVD diamond film grown according to the present invention is prepared, as in the first embodiment, by removing any non-electronic grade diamond or other material from the areas to be metallized for the active device.

A plurality of parallel conductive strips, preferably comprising a titanium/gold film layer, are disposed on the surface of the diamond film and spaced apart by a selected active region distance. Alternating ones of the conductive strips are electrically connected to one another, preferably by one of two regions of the titanium/gold film layer disposed adjacent to the periphery of the measuring area of the film and running orthogonal to and in contact with alternating ones of the conductive strips to form an interlaced comb-like pattern.

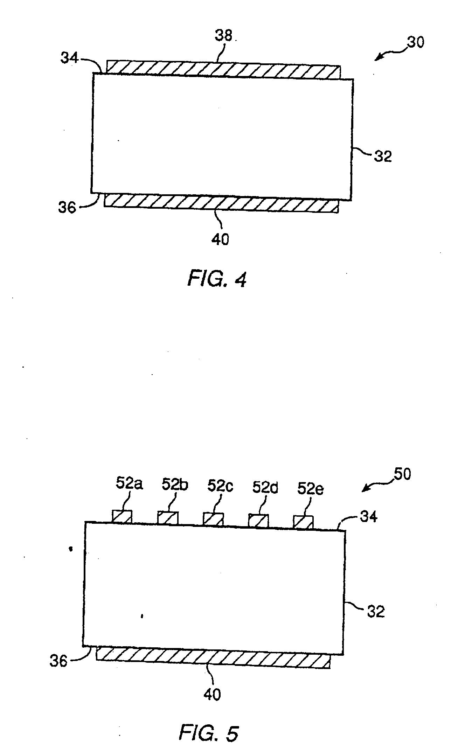

Referring now to FIG. 4, a cross sectional view of a first embodiment of a bulk radiation detector 30 according to the present invention is shown. Detector 30 comprises a block 32 of diamond film having an upper surface 34 and a lower surface 36, and has a thickness of between about 10 microns and several hundred microns, depending on the application in which the detector will be used. An upper layer of conductive film 38, preferably a titanium/gold film as described herein, is disposed on upper surface 34 of block 32, and a lower layer of conductive film 40 is disposed on lower surface 36 of block 32.

According to the present invention, the embodiment of FIG. 4 may be fabricated by a process in which non-electronic grade CVD diamond material is first removed from the surface of the already-grown bulk diamond film. This step may include removal of the silicon, molybdenum, or CVD diamond substrate layer prior to metallization. This step is performed using conventional materials-processing etch steps.

The upper and lower layers 38 and 40 of conductive film are respectively disposed over an area of about 1 mm² or larger on each of the upper and lower surfaces of the block of diamond film. The upper and lower metal film layers are aligned to one another.

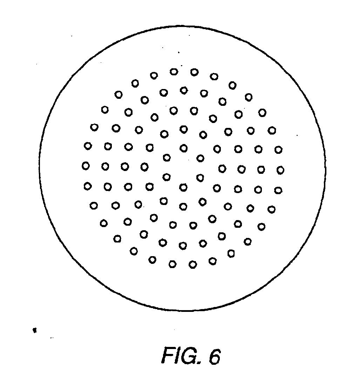

Referring now to FIG. 5 , a cross sectional view of a second embodiment of a bulk detector 50 according to the present invention is presented. As in the embodiment of FIG. 4, a layer of conductive film 40, preferably comprising a deposited titanium/gold layer, is disposed over an area of about 1 mm² or larger on the lower surface 36 of block 32. A plurality of spaced-apart parallel conductive strips 52a-52e are shown- disposed on the upper surface of the block 32. Strips 52a-52e may be formed by etching a conductive layer such as layer 38 of FIG. 4 using conventional techniques. The embodiment of FIG. 5 comprises five separate detectors sharing common lower conductive layer 40 between them.

According to a third aspect of the present invention a chemical-vapor-deposition method is presented for producing diamond materials suitable for use as radiation detectors according to the present invention. The diamond material of the present invention is grown on a suitable substrate material. Appropriate substrates include large grain polycrystalline diamond, single crystal diamond, diamond particulate composites and other non-diamond substrates that allow for large grain growth.

Key features of detector-grade CVD diamond film production involve utilizing the appropriate chemistry during growth and performing the growth process on appropriate substrates to allow for large-grain diamond growth. As presently preferred, appropriate substrates include large-grain polycrystalline diamond, single crystal diamond, diamond particulate composites such as diamond-silicon carbide, diamond-diamond, and diamond-boron nitride, and other non-diamond substrates that allow for large grain growth, such as silicon and molybdenum.

Diamond-diamond, and diamond-non-diamond composite substrates suitable for use in the present invention may be fabricated by utilizing the methods taught in co-pending application serial No. 07/704,997, filed May 24, 1991, and assigned to the same assignee as the present invention. This patent application is expressly incorporated herein by reference. Silicon and molybdenum substrates may be prepared by diamond polishing as is known in the art.

According to the present invention, detector-grade diamond can be grown on the disclosed substrates in a microwave plasma CVD system. Diamond materials suitable for use as radiation detectors according to the present invention have been successfully grown in a NIRIM style reactor. The CVD reactor used in the present invention should employ only quartz and molybdenum fixtures, and should employ only molybdenum components in the hot regions of the reactor, and should be free of graphite fixtures and other graphite contamination.

Such a reactor actually used to grow films according to the present invention has a reactor-chamber volume of about 300 in³ and may preferably be equipped with a gas delivery system employing a showerhead fixture as shown in FIG. 6. As presently preferred, the showerhead has a generally circular delivery face having a diameter of about 3.5 inches. The delivery face includes a plurality of gas delivery holes formed therethrough. The holes each have a diameter of about 0.020 inch and are equally spaced in a pattern comprising five concentric circles. A first inner circle having a diameter of about 0.5 inch includes 6 holes; a second circle having a diameter of about 1.0 inch includes 12 holes; a third circle having a diameter of about 1.5 inch includes 18 holes; a fourth circle having a diameter of about 2.0 inch includes 24 holes; a fifth circle having a diameter of about 2.5 inch includes 30 holes. The showerhead is positioned in the chamber at 3.5 cm to 5 cm above the substrate.

Microwave energy of 2.45 GHz at a power level of between about 1,400 to 1,900 watts is introduced into the reaction chamber using conventional waveguides to create a plasma in the region of a substrate holder and achieve a substrate temperature of between about 800-1,000°C as measured by a dual-frequency optical pyrometer.

The reaction may be carried out in an atmosphere of 300 sccm of hydrogen, 3 sccm of methane and 4.5 sccm of carbon monoxide at pressures from 90-100 Torr and substrate temperatures of 800-1000° C. Those of ordinary skill in the art will realize that gas flow rates may be adjusted for different-sized reaction chambers.

The present invention allows for the fabrication and production of CVD diamond detectors. Diamond detectors can be utilized in a number of applications including, but not confined to radiation-detectors useful for high-energy physics applications and other similar high energy applications, radiation sensors for the medical community, detectors for commercial x-ray inspection of critical components, ultraviolet detectors for commercial analytical instruments and high energy physics experiments. CVD diamond detectors used in all of these areas will provide improved reliability and radiation tolerance of current solid state detectors. Due to the nature of CVD diamond films, these detectors can easily be fabricated in large dimensions and for a lower cost than natural diamond detectors.

It is possible using the radiation detectors of the present invention to base key sections of tracking and calorimetry on diamond technology in high-energy physics experiments. These include a diamond charged particle tracking chamber (diamond tracker), diamond electromagnetic calorimeter, and diamond-tungsten hadron calorimeter all of which will reside inside a 5 Tesla magnetic volume. Using the detectors of the present invention allows operation at luminosities above 10³⁴ cm⁻²s⁻¹ in a hadron collider. Moreover, limiting the number of distinct elements in a compact detector should keep the final design simple and economical.

To use the diamond radiation detectors disclosed herein, a few hundred volts are applied across a layer of diamond a few hundred microns thick. When a charged particle traverses the diamond, atoms at the crystal lattice sites are ionized, promoting electrons into the conduction band and leaving holes in the valence band. These charges are free to move about the crystal and drift across the layer in response to the applied electric field producing a signal pulse which can be preamplified and further processed into a detection signal.

There are few systematic studies of radiation damage to diamond detectors. However, there is a study by Kozlov et al. which shows that a diamond detector can survive up to a few times 10¹⁴ neutrons/cm2, which is about two orders of magnitude higher than for silicon detectors.

While embodiments and applications of this invention have been shown and described, it would be apparent to those skilled in the art that many more modifications than mentioned above are possible without departing from the inventive concepts herein. The invention, therefore, is not to be restricted except in the spirit of the appended claims.

## Claims

1. A chemical-vapor-deposition diamond film having an average grain size of at least 7 microns and containing minimal hydrogen, said diamond film having a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm.

2. The chemical-vapor-deposition diamond film of claim 1 having a thickness of at least about 1 micron.

3. The chemical-vapor-deposition diamond film of claim 1 having a thickness of between about 10 microns and 500 microns.

4. A surface radiation detector comprising:
a chemical-vapor-deposition diamond film having an average grain size of at least 7 microns and containing minimal hydrogen, said diamond film having a thickness of at least about 1 micron, a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm;
a set of first parallel conductive strips and a second set of parallel conductive strips offset from and spaced apart from said first set of parallel strips, disposed on a surface of said diamond film to form a plurality of active detector areas in regions between pairs of said first and second conductive strips thereon.

5. A surface radiation detector comprising:
a chemical-vapor-deposition diamond film having an average grain size of at least 7 microns and containing minimal hydrogen, said diamond film having a thickness of at least about 1 micron, a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm;
a plurality of parallel conductive strips disposed on a surface of said diamond film, individual ones of said parallel conductive strips spaced apart by a selected active region distance, alternating ones of said conductive strips being electrically connected to one another.

6. The surface radiation detector of claim 5 wherein said alternating ones of said conductive strips are electrically connected to one another by connective conductive strips disposed at opposing ends of said active region, each of said connective conductive strips running orthogonal to and in contact with alternating ones of said conductive strips to form an interlaced comb-like pattern.

7. A bulk radiation detector comprising:
a block of chemical-vapor-deposition diamond film having a first surface and a second surface, and having a thickness of between about 10 microns and 500, an average grain size of at least 7 microns and containing minimal hydrogen, said diamond film having a thickness of at least about 1 micron, a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm;
a first layer of conductive film disposed over said first surface of said diamond film; and
a second layer of conductive film disposed over said second surface of said diamond film, said second layer substantially aligned to said first layer.

8. A bulk radiation detector comprising:
a block of chemical-vapor-deposition diamond film having a first surface and a second surface, and having a thickness of between about 10 microns and 500, an average grain size of at least 7 microns and containing minimal hydrogen, said diamond film having a thickness of at least about 1 micron, a resistivity of at least 10¹⁰ Ω-cm, a carrier mobility of at least 1,000 cm²/V-sec, a carrier lifetime of at least 100 psec and less than 200 nsec, yielding a collection distance of at least 10 microns at an electric field strength of 10⁴ V/cm;
a first layer of conductive film disposed over said first surface of said diamond film; and
a plurality of spaced apart parallel conductive strips disposed on conductive film disposed over said second surface of said diamond film, said plurality of spaced apart parallel conductive strips substantially aligned to said first layer of conductive film.

9. A process for growing CVD diamond suitable for use as a radiation detector, comprising the steps of:
providing a NIRIM style CVD reactor, said reactor employing only molybdenum components in hot regions thereof, and being substantially free of graphite;
placing a substrate on a substrate holder in said reactor and closing said reactor;
providing an atmosphere in said reaction chamber comprising about 300 sccm of hydrogen, about 3 sccm of methane and about 4.5 sccm of carbon monoxide at a pressure of from about 90-100 Torr; and
providing microwave energy of 2.45 GHz at a power level of between about 1,400 to 1,900 watts into said reactor so as to create a plasma in the region of said substrate holder and achieve a substrate temperature of between about 800-1,000°C for a time sufficient to grow a desired thickness of CVD diamond material.
